# EUROPEAN PATENT APPLICATION

(11) **EP 1 528 642 A2**
(43) Date of publication of application: **04.05.2005**
(21) Application number: 04025640.6
(22) Date of filing: 28.10.2004
(51) Int. Cl.: H01R 43/00, H01R 13/24, H05K 3/32, H05K 3/36

(54) **Production method of anisotropic conductive film**

(30) Priority: 30.10.2003 JP 2003371206
(71) Applicant: NITTO DENKO CORPORATION, Ibaraki-shi, Osaka 567-8680 (JP)
(72) Inventor: Asai, Fumiteru c/oNitto Denko Corporation, Ibaraki-shi Osaka 567-8680 (JP); Noro, Masato c/oNitto Denko Corporation, Ibaraki-shi Osaka 567-8680 (JP)
(74) Representative: von Kreisler Selting Werner

(57) **Abstract**

The present invention aims at providing a method of producing a highly reliable anisotropic conductive film having conductive paths disposed at a narrow pitch and comparatively highly protruding from the principal plane of a film substrate, which is free of a short-circuit (contact) of the ends of adjacent conductive paths and an unprotruded conductive path. The production method of the present invention includes preparing a structural precursor wherein plural conductive paths (52) comprising conductive wires penetrate a film substrate (51) made from an insulating polymer in the thickness direction thereof, while being insulated from each other and the end face of each conductive path (52) is present in the same plane as the principal plane of the film substrate (51), and applying a reactive ion etching to the principal plane of the film substrate (51) to allow the ends (52a,52b) of the conductive path (52) to protrude from the principal planes (51a,51b) of the film substrate (51).

## Description

### FIELD OF THE INVENTION

The present invention relates to an anisotropic conductive film, particularly a production method of an anisotropic conductive film wherein the end of a conductive path protrudes from the principal plane of a film substrate.

### BACKGROUND OF THE INVENTION

By inserting an anisotropic conductive film between an electronic component such as a semiconductor element and a circuit board and pressing them, an electric connection between the electronic component and the circuit board is obtained. Therefore, an anisotropic conductive film has been widely used as a test connector for a functional test of electronic components such as semiconductor element and the like.

The use of an anisotropic conductive connector as a test connector is necessary because a functional test of an electronic component after mounting the electronic component on a circuit board to prove the electronic component to be defective results in disposal of a good circuit board together with the component, thereby lowering the production efficiency of the circuit board and increasing an economical loss. Namely, by bringing an electronic component such as a semiconductor element into contact with a circuit board via an anisotropic conductive film at the same position as being mounted, a functional test of the electronic component can be performed without actually mounting the component on the circuit board. As a result, the above-mentioned problems can be avoided.

The present Applicant already proposed an anisotropic conductive film, wherein plural conductive paths made from an electrically conductive material are arranged in a film substrate made from an insulating material while penetrating the film substrate in the thickness direction thereof (WO98/07216, USP 6,245,175). The present Applicant also suggested that a conductive path can be brought into contact with an electronic component at a lower pressure by inclining the conductive path such that the center line of a conductive path forms an angle with the line perpendicular to the principal plane of the film substrate, as a result of which, damages to and deformation of terminals caused during a functional test of an electronic component can be prevented (WO98/07216, USP 6,245,175). In addition, the present Applicant suggested protruding the end of a conductive path from a principal plane of a film substrate so as to facilitate contact between an electronic component terminal and the conductive path (JP-A-2000-221209, USP 6,597,192).

### SUMMARY OF THE INVENTION

In recent years, electronic components such as semiconductor element have been progressively highly integrated, and the size of an electrode (terminal) has been made smaller, the number of electrodes (terminals) has increased and the distance between terminals has become smaller. Moreover, terminals disposed in an electronic component in a great number may be of a narrow pitch and the surface of a terminal may be set back from the surface of the component itself. For application to such an electronic component, the conductive path of an anisotropic conductive film needs to have a smaller outer diameter (thickness), sequenced at a narrow pitch, and protruded longer from the principal plane of a film substrate. As a result of the study of the present inventors, however, it has been found that, when the end of a conductive path disposed at a narrow pitch is protruded from the principal plane of a film substrate by not less than 5 µm (further not less than 10 µm) by a plating treatment as has been conventionally done, protrusions (ends) of adjacent conductive paths sometimes come into contact. An anisotropic conductive film prior to protrusion of the end of a conductive path by a plating treatment, which is free of protrusion of a conductive path was conventionally prepared as in the following in view of the production efficiency. To be specific, a conductive wire comprising an insulating resin coated around the circumference of a conductive wire is wound, subjected to heating and pressing to give an integrated block, which is cut along a cutting plane forming an angle with the center line of the conductive wire (WO98/07216, USP 6,245,175). However, plural ends of a conductive path (end face) that the anisotropic conductive film obtained by this production method has are sometimes set back from the surface of a film substrate. It has been realized that such a conductive path may fail to form a protrusion even if it is subjected to a plating treatment.

In view of the above-mentioned situation, the present invention aims at providing a method of producing a highly reliable anisotropic conductive film having conductive paths disposed at a narrow pitch and comparatively highly protruding from the principal plane of a film substrate, which is free of a short-circuit (contact) of the ends of adjacent conductive paths and an unprotruded conductive path.

To solve the above-mentioned problems, the present invention has the following constitution.
(1) A method of producing an anisotropic conductive film, which comprises preparing a structural precursor comprising a film substrate made from an insulating polymer and plural conductive paths comprising conductive wires, which penetrate in the thickness direction of the film substrate while being insulated from each other, wherein an end face of each conductive path is in the same plane as the principal plane of the film substrate, applying reactive ion etching to the aforementioned principal plane of the film substrate to protrude the aforementioned end of the conductive path from the aforementioned principal plane of the film substrate.
(2) The production method of the above-mentioned (1), which further comprises a plating treatment of the end of the conductive path after the aforementioned reactive ion etching.
(3) The production method of the above-mentioned (1) or (2), wherein the structural precursor is prepared by the following method (A).
   (A): winding an insulating polymer film around the circumference of a core,
      then helically winding a conductive wire around the circumference of the insulating polymer film at a predetermined pitch,
      heating and pressurizing to integrate the insulating polymer film and the conductive wire on the core to give a roll-like product,
      removing said roll-like product from the core,
      incising the roll-like product to give a plane-like product,
      cutting out plural films with conductive wires from the plane-like product,
      then laminating the plural films with conductive wires such that the conductive wires on the adjacent films are parallel to each other to give a laminate,
      heating and pressurizing the laminate to form a block integrating the plural films with conductive wires, and then cutting the block in a predetermined film thickness along the plane forming an angle with the conductive wire to give the structural precursor.
(4) The production method of the above-mentioned (3), wherein the insulating polymer film and the conductive wire wound around the core are set together with the core in a space permitting formation of a decompression or vacuum and, after decompressing or vacuumizing the space, heated and pressurized to integrate the insulating polymer film and the conductive wire on the core.
(5) The production method of the above-mentioned (4), wherein said space permitting formation of a decompression or vacuum is an inner space of a bag made of a flexible film.
(6) The production method of the above-mentioned (4) or (5), wherein said pressing is done by introducing a compressed air into said space permitting formation of a decompression or vacuum.
(7) The production method of any of the above-mentioned (3) - (6), wherein the laminate is set in a space permitting formation of a decompression or vacuum, and after decompressing or vacuumizing the space, heated and pressurized.
(8) The production method of the above-mentioned (7), wherein the space permitting formation of a decompression or vacuum is an inner space of a bag made of a flexible film.
(9) The production method of the above-mentioned (7), wherein the laminate is housed in a heat resistant box having a size leaving some clearance between the inside surface of the box and the lateral surface of the laminate upon accommodation of the laminate, set in the space inside the bag made of a flexible film together with the heat resistant box, and after decompressing or vacuumizing the space, heated and pressurized.

In the present invention, a conductive wire is used as a conductive path, an anisotropic conductive film (structural precursor) having an end face of the conductive path and the principal plane of a film substrate in the same plane is prepared, and the film substrate of the anisotropic conductive film (structural precursor) is subjected to reactive ion etching to make the end of the conductive path protrude from the principal plane of the film substrate. This has an effect that dispersion in the protrusion height and thickness of plural conductive paths can be minimized, and occurrence of a conductive path without protrusion of an end can be prevented. As a result, a highly reliable anisotropic conductive film comprising only an extremely small number of defects, where the ends of adjacent conductive paths are short-circuited (contacted) and protrusion has not been formed, can be produced in a high yield.

### BRIEF DESCRIPTION OF THE DRAWINGS

Fig. 1(a) is a plan view of one embodiment of the anisotropic conductive film produced by the present invention, and Fig. 1(b) is a sectional view thereof.
Fig. 2 shows a schematic view of the section of the major parts of another embodiment of the anisotropic conductive film produced by the present invention.
Fig. 3 includes a perspective view (Fig. 3(a)) of winding an insulating polymer film around a core, and a perspective view (Fig. 3(b)) of a wound product obtained by such step, in the production step of the anisotropic conductive film of the present invention.
Fig. 4 is a plane view of a plane-like product obtained by developing a roll-like product integrating insulating polymer films and conductive wires.
Fig. 5(a) and Fig. 5(b) are plane views of plural films with conductive wires obtained by cutting the plane-like product.
Fig. 6 includes a perspective view (Fig. 6(a)), a sectional view (Fig. 6(b)) and a plane view (Fig. 6(c)) of a film with conductive wires.
Fig. 7 is a perspective view showing an accumulation work of films with conductive wires (Fig. 6).
Fig. 8 is a perspective view of a laminate obtained by laminating the films with conductive wires (Fig. 6).
Fig. 9 is a perspective view of a block integrating laminate (Fig. 8) by heating and pressurizing.
Fig. 10 is a perspective view of a step of placing a laminate (Fig. 8) into a heat resistant box.
Fig. 11 is a perspective view of a state wherein the laminate (Fig. 8) is housed in the heat resistant box.
Fig. 12 is a perspective view of a step of cutting a film from the block (Fig. 9).

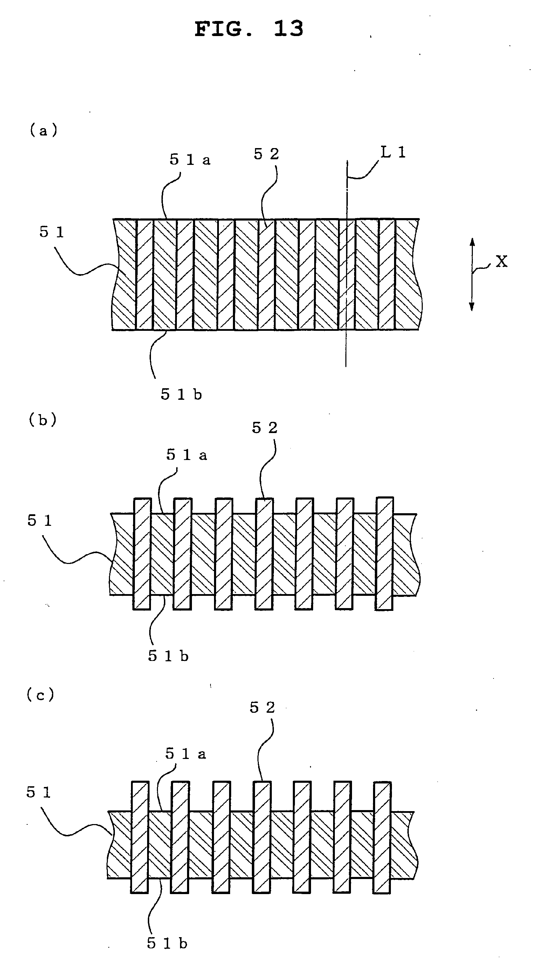

Fig. 13(a) is a sectional view of a major part of an anisotropic conductive film (structural precursor), wherein the center line of a conductive path is substantially parallel to the thickness direction of the film substrate, and the end of the conductive path is not protruded, Fig. 13(b) and Fig. 13(c) are sectional views of a major part of an anisotropic conductive film obtained by subjecting both principal planes of a structural precursor to RIE, where, in Fig. 13(b), the protrusion height of the end of the conductive path is substantially the same on the both principal planes of the anisotropic conductive film and in Fig. 13(c), the protrusion height differs between the both principal planes of the film.

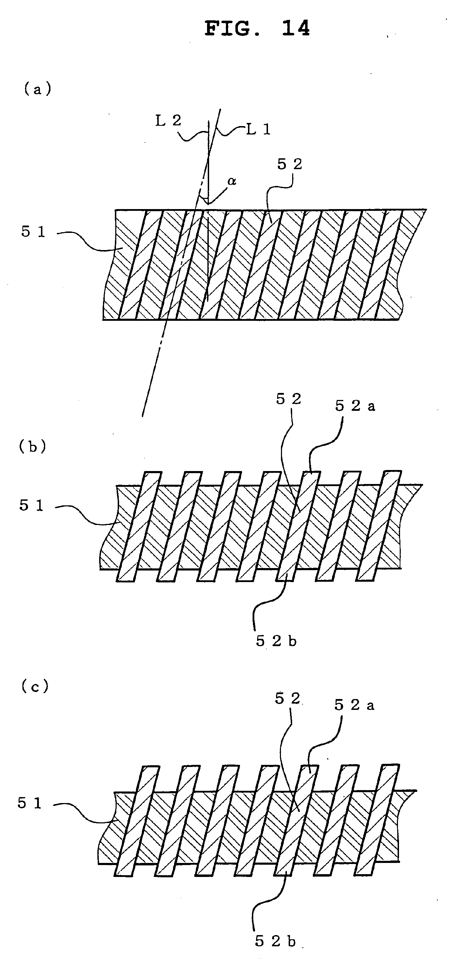

Fig. 14(a) is a sectional view of a major part of an anisotropic conductive film (structural precursor), wherein the center line of a conductive path forms an angle (α) with the line perpendicular to the principal plane of the film substrate, and the end of the conductive path is not protruded, Fig. 14(b) and Fig. 14(c) are sectional views of a major part of an anisotropic conductive film obtained by subjecting both principal planes of a structural precursor to RIE, where, in Fig. 14(b), the protrusion height of the end of the conductive path is substantially the same on the both principal planes of the anisotropic conductive film and in Fig. 14(c), the protrusion height differs between the both principal planes of the film.
Fig. 15 shows one embodiment (houndstooth check) of the conductive paths in sequence in the film substrate.

The symbols of each of the above-mentioned Figures mean as follows.
- 51: film substrate made from insulating polymer
- 51a, 51b: principal plane of film substrate
- 52: conductive path
- 52a, 52b: end of conductive path

### DETAILED DESCRIPTION OF THE INVENTION

The present invention is explained in detail in the following.

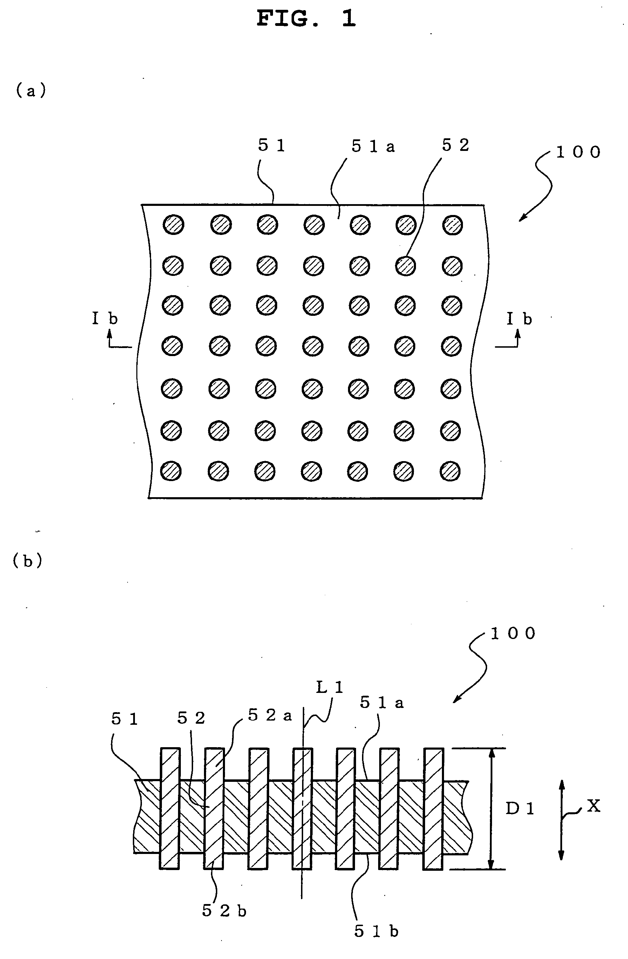

Fig. 1(a) is a schematic view of one embodiment of the anisotropic conductive film produced by the present invention, wherein Fig. 1(a) is a plan view and Fig. 1(b) is a sectional view of Fig. 1 (a) along the cutting line Ib-Ib. As shown in Fig. 1, an anisotropic conductive film 100 produced by the present invention comprises a film substrate 51 made from an insulating polymer and plural conductive paths 52 made from an electrically conductive material, said plural conductive paths 52 penetrating in the thickness direction of the film substrate 51, while being insulated from each other in the film substrate 51, and ends 52a, 52b of the conductive path 52 protrude from the both principal planes 51a, 51b of the film substrate 51.

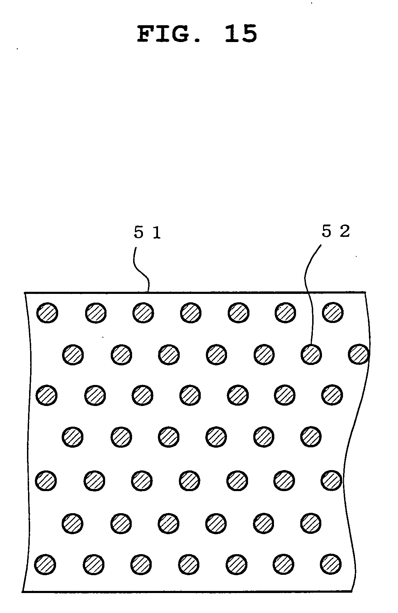

The outer diameter of each conductive path 52 of the anisotropic conductive film produced by the present invention is preferably 10 - 100 µm, more preferably 10 - 60 µm. An average distance between adjacent conductive paths (distance between the center lines of adjacent conductive paths) is preferably 20 - 200 µm, more preferably 20 - 150 µm. The anisotropic conductive film produced by the present invention is suitable for the testing of the function of an electronic component by inserting the film between the electronic component and a circuit board for testing. The aforementioned electronic component has plural terminals, and the distance between the centers of the adjacent terminals is preferably not more than 200 µm, more preferably not more than 150 µm. From the aspects of easy contact of the terminal of electronic component and circuit pattern of circuit board, the section of the conductive path in the anisotropic conductive film is preferably a circle, or a shape other than a circle, such as a polygon (e.g., rectangle, square). When the section of a conductive path is a circle, the outer diameter (thickness) of the conductive path is a diameter of the section, and when the section of a conductive path is a shape other than a circle, the outer diameter (thickness) of the conductive path is a diameter of a circle having the same sectional area. The sequence of conductive paths 52 in the film substrate 51 is generally a square matrix shown in Fig. 1(a), a houndstooth check shown in Fig. 15 and the like.

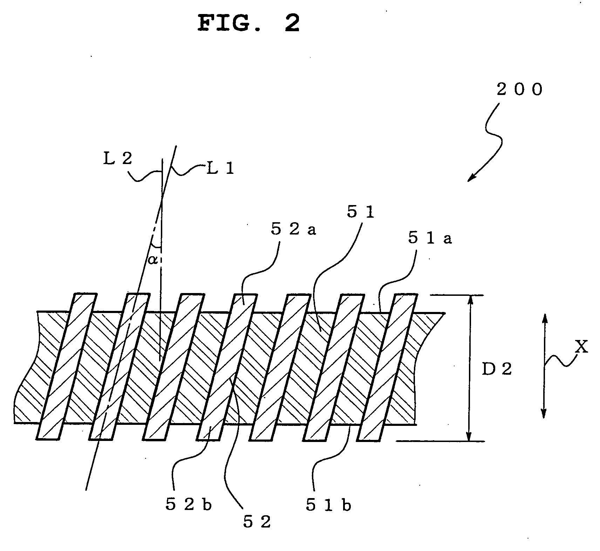

Fig. 2 is a schematic view of a section of major part of a different embodiment of the anisotropic conductive film ' produced by the present invention. In this anisotropic conductive film 200, each conductive path 52 is inclined, and the center line L1 of the conductive path 52 preferably forms an angle (α) of 5 - 45° with the perpendicular line L2 of the principal plane of the film substrate 2. An inclined conductive path as this one bends upon contact with the terminal of an electronic component and the like and advantageously further decreases the load applied to the terminal.

The anisotropic conductive film produced by the present invention preferably has a thickness of 30 - 1000 µm, more preferably 50 - 500 µm. When the thickness exceeds 1000 µm, the distance between a test subject and a circuit board for testing increases and makes the mounting state quite different from the actual mounting state. When the thickness is less than 30 µm, a warp of the component and inconsistent height of the terminal cannot be absorbed. The thickness of the anisotropic conductive film 100, wherein the center line L1 of the conductive path 52 is substantially parallel to the thickness direction of the film substrate (direction of arrow X in Fig. 1) as shown in Fig. 1 is defined by D1 in Fig. 1(b), namely, full length of the conductive path 52. The thickness of the anisotropic conductive film 200 wherein the center line L1 of the conductive path 52 forms an angle with line L2 perpendicular to the principal plane of the film substrate 51 (thickness direction of film substrate), as shown in Fig. 2, is defined by D2 of Fig. 2, namely, the distance, in the thickness direction (direction of arrow X in Fig. 2) of the film substrate 51, between the tip of the conductive path 52a protruding on one principal plane 51a side of the film substrate 51 and the tip of a conductive path 52b protruding on the other principal plane 51b.

To facilitate contact between the tip of the conductive path and a terminal of an electronic component and circuit pattern (wiring pattern) of a circuit board to be tested, both ends of the conductive path of the anisotropic conductive film produced by the present invention protrudes from both principal planes of the film substrate. In this case, the protrusion height from each principal plane of the film substrate at the end of the conductive path is preferably 5 - 40 µm. This is determined in consideration of easy contact with a terminal and a circuit pattern and prevention of deformation of a conductive path during testing. A conductive path having a protrusion height of less than 5 µm cannot easily contact the terminal of an electronic component or a circuit pattern of a circuit board. A conductive path exceeding a protrusion height of 40 µm, the end of the conductive path may be deformed when a load (pressure) is applied to an anisotropic conductive film.

More specifically, the protrusion height of the end of a conductive path from the principal plane opposite to an electronic component is preferably 10 - 40 µm, more preferably 10 - 30 µm, and the protrusion height of the end of a conductive path from the principal plane opposite to a circuit board is preferably 5 - 20 µm, more preferably 5 - 10 µm.

When the protrusion height of the end of the conductive path from the principal plane opposite to an electronic component is less than 10 µm, the conductive path is not easily brought into contact with the terminal of a component whose surface is lower than the surface of the component, and when it exceeds 40 µm, the protrusion of the end of the conductive path tends to be deformed during a test. In addition, when the protrusion height of the end of the conductive path from the principal plane opposite to a circuit board is less than 5 µm, the conductive path comes to resist easy contact with a circuit board (circuit) in the repeated use, and when it exceeds 20 µm, a protrusion part of the conductive path tends to be deformed by the repeated use.

The production method of the anisotropic conductive film of the present invention comprises, as mentioned above, preparing a structural precursor comprising a film substrate made from an insulating polymer and plural conductive paths comprising conductive wires, which penetrate in the thickness direction of the film substrate while being insulated from each other, wherein an end face of each conductive path is in the same plane as the principal plane of the film substrate, applying reactive ion etching to the aforementioned principal plane of the film substrate to protrude the aforementioned end of the conductive path from the aforementioned principal plane of the film substrate.

As used herein, a structural precursor, which is an anisotropic conductive film free of protrusion of the end of a conductive path, can be produced by a known production method of an anisotropic conductive film. For example, the method may comprise winding a conductive wire comprising an insulating resin coated around the circumference of a conductive wire, subjected same to heating and pressing to give an integrated block, which is cut along a cutting plane forming an angle with the center line of the conductive wire, as described in USP6,245,175. A method comprising the following Steps 1 to 3 is preferable from the aspect of forming a regular sequence of conductive paths in an anisotropic conductive film, from the aspect of making deformation of an anisotropic conductive film more uniform, and decreasing the dispersed incline angles (α) of the conductive path with the perpendicular line to the principal plane of a film substrate. The method includes winding an insulating polymer film around the circumference of a core, then helically winding a conductive wire around the circumference of the insulating polymer film at a predetermined pitch, heating and pressurizing to integrate the insulating polymer film and the conductive wire on the core to give a roll-like product, removing said roll-like product from the core, incising the roll-like product to give a plane-like product, cutting out plural films with conductive wires from the plane-like product, then laminating the plural films with conductive wires such that the conductive wires on the adjacent films are parallel to each other to give a laminate, heating and pressurizing the laminate to form a block integrating the plural films with conductive wires, and then cutting the block in a predetermined film thickness along the plane forming an angle with the conductive wire to give the anisotropic conductive film (structural precursor).

### [Step 1 (step for forming plural films with conductive wires)]

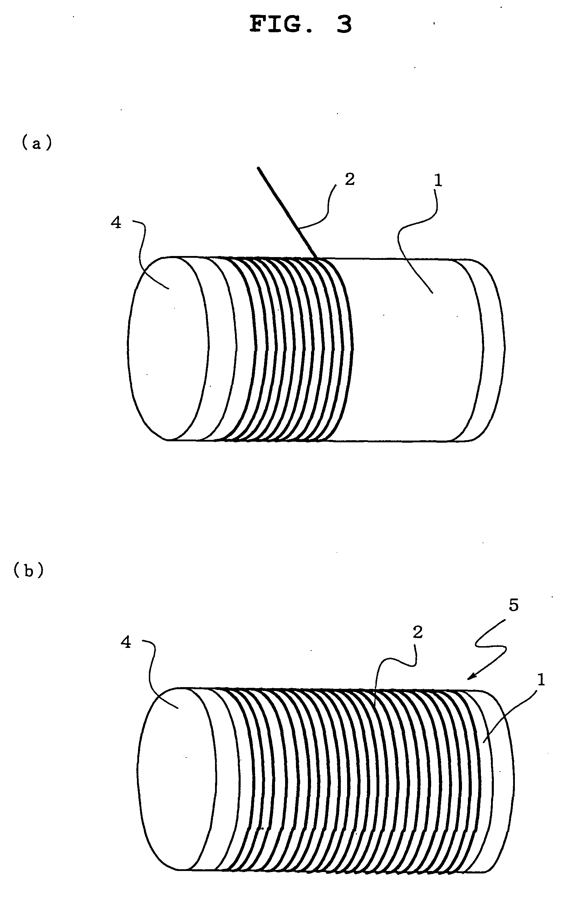

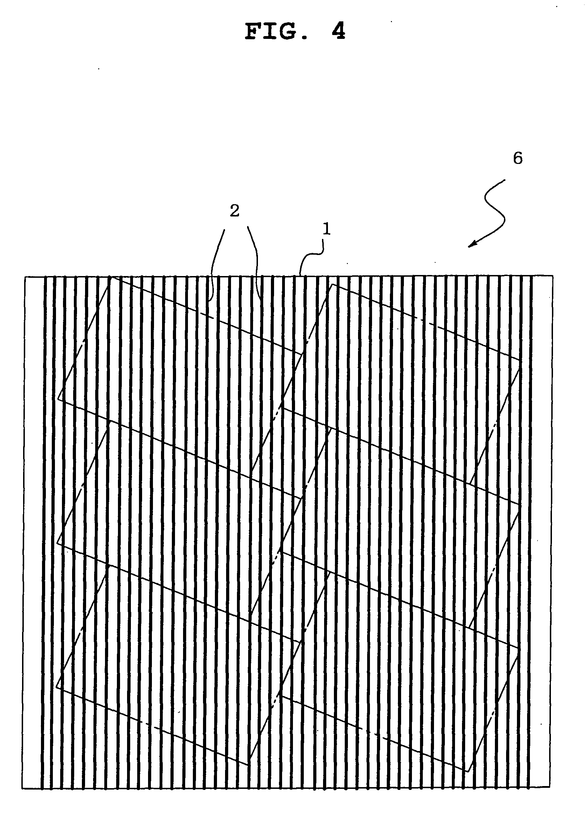

As shown in Fig. 3(a), an insulating polymer film 1 is wound around the circumference of a core 4, then one conductive wire 2 is helically wound at a predetermined pitch around the circumference of insulating polymer film 1 to form a wound product 5 (Fig. 3(b)). The winding here can be done using a known winding machine such as a horizontal type regularly winding machine and the like. Then the wound product 5 (Fig. 3(b)) is heated and pressurized to integrate the insulating polymer film 1 and the conductive wire 2 on the core 4 to give a roll-like product. Then the roll-like product integrating the insulating polymer film 1 and the conductive wire 2 is removed from the core 4, a part of the roll-like product is cut to open into a plane-like product 6 (Fig. 4), which is then cut to give plural films with conductive wires.

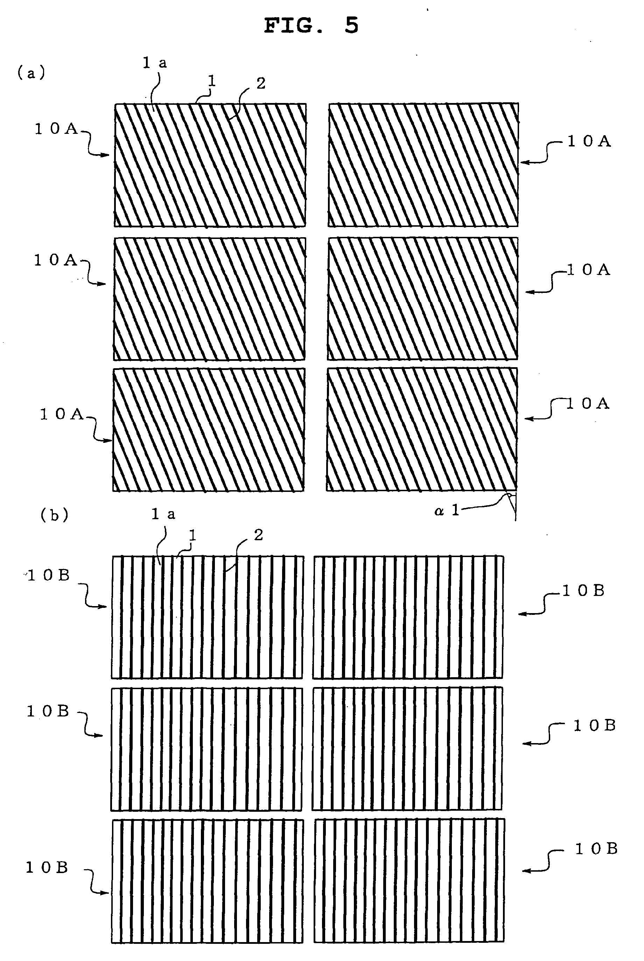

Fig. 5(a) and Fig. 5(b) show embodiment of the plural films with conductive wires. The film with conductive wires 10A shown in Fig. 5(a) is cut out from the plane-like product 6 (Fig. 4) such that the principal plane 1a of the insulating polymer film 1 is rectangular, and the direction of (the center line of) the conductive wire 2 has an inclination toward the predetermined one side (linear side) of the rectangular principal plane 1a of the insulating polymer film 1, and the film with conductive wires 10B of Fig. 5(b) is cut out from the plane-like product 6 (Fig. 4) such that the principal plane 1a of the insulating polymer film 1 is rectangular and the direction of (the center line of) the conductive wire 2 is parallel and perpendicular to the sides (4 sides) of the rectangular principal plane 1a of the insulating polymer film 1. The double-dotted line in Fig. 4 shows the cutting line of the film with conductive wires 10A of Fig. 5 (a) .

The film with conductive wires 10B in Fig. 5(b) is mainly used when producing an anisotropic conductive film 100 (Fig. 1) wherein the center line L1 of the conductive path 52 is substantially parallel to the thickness direction (direction of arrow X in Fig. 1) of the film substrate. Using the film with conductive wires 10B and cutting the block in the direction perpendicular to the center line of the conductive wires 2 in Step 3 to be mentioned below, an anisotropic conductive film (structural precursor) wherein the center line of each conductive path is parallel to the thickness direction of the film substrate can be obtained.

On the other hand, for production of an anisotropic conductive film wherein the conductive path 52 is inclined such that the center line L1 of the conductive path 52 forms an angle (α) with the perpendicular line L2 of the principal plane of film substrate 2, as shown in Fig. 2, a film with conductive wires 10A of Fig. 5(a) is suitable. The film with conductive wires 10A intends to previously set the angle (α) formed by (the center line L1 of) the conductive path 52 with the line L2 perpendicular to the principal plane 51a of the film substrate 51 in the anisotropic conductive film 10A to be finally produced by defining the inclination angle (inclination angle (α1) relative to the predetermined linear side in the principal plane 1a of the insulating polymer film 1) of (the center line of) the conductive wire 2 in the film with conductive wires 10A. By the use of the film with conductive wires 10A, anisotropic conductive film (structural precursor) wherein plural conductive paths are inclined at an angle (α), can be obtained by merely cutting the block along the plane perpendicular to the predetermined linear edge side (one side derived from the linear side of the principal plane 1a of the insulating polymer film 1) in a later Step 3 (step for cutting the block integrating plural films with conductive wires).

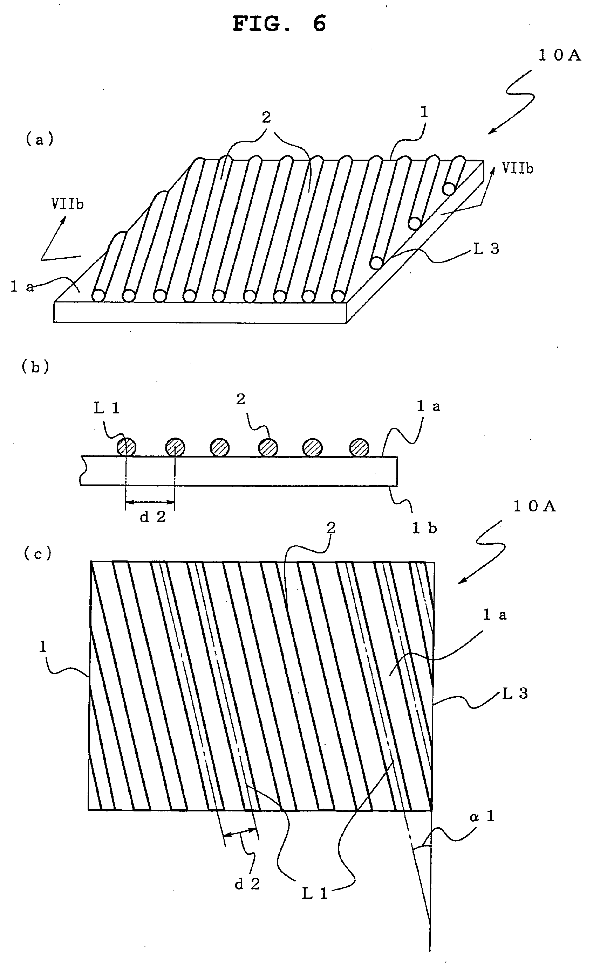

Fig. 6 is an enlarged view of the above-mentioned film with conductive wires 10A (Fig. 6(a) is a perspective view, Fig. 6(b) is a sectional view and Fig. 6(c) is a plane view). In the film with conductive wires 10A, plural conductive wires 2 arranged in parallel to each other at a predetermined pitch (d2) are adhered onto the rectangular principal plane 1a of the insulating polymer film 1, and (each center line L1 of) the plural conductive wires 2 form a predetermined inclination angle (α1) with the predetermined linear side L3 of the principal plane 1a of the insulating polymer film 1, and are positioned in parallel to the principal plane 1a. As used herein, by the "form a predetermined inclination angle (α1)" is meant that the center line L1 of the conductive wire and the linear side L3 cross at the predetermined inclination angle (α1) as shown in Fig. 6(c) (i.e., not perpendicular intersection or parallel), when the principal plane 1a of the insulating polymer film is seen from the vertical above. The predetermined inclination angle (α1) is, as explained above, corresponds to the angle (α) formed by (the center line L1 of) the conductive path 52 with the line L2 perpendicular to the principal plane 51a (51b) of the film substrate 51 in the anisotropic conductive film (Fig. 2) to be produced.

The insulating polymer film 1 constitutes the film substrate 51 of an anisotropic conductive film. As materials constituting the insulating polymer film 1, for example, thermoplastic or thermosetting resins such as thermoplastic polyimide resin, epoxy resin, polyetherimide resin, polyamide resin, silicone resin, phenoxy resin, acrylic resin, polycarbodiimide resin, fluorocarbon resin, polyester resin, polyurethane resin and the like; thermoplastic elastomers such as thermoplastic polyurethane elastomer, thermoplastic polyester elastomer, thermoplastic polyamide elastomer and the like; and the like can be mentioned. Of these, thermoplastic elastomers are preferable materials for increasing the flexibility of an anisotropic conductive film. In addition, insulating polymer may contain various materials such as filler, plasticizer and rubber material. Examples of the filler include SiO₂ and Al₂O₃, examples of the plasticizer include TCP (tricresyl phosphate) and DOP (dioctyl phthalate), examples of the rubber material include NBS (acrylonitrile-butadiene rubber), SBS (polystyrene-polybutylene-polystyrene) and the like.

The conductive wire 2 constitutes the conductive path 52 of the anisotropic conductive film. For the conductive wire 2, a wire-like product made of an electrically conductive material, or a wire-like product made of an electrically conductive material, which is coated with an insulating material and which is what is called an insulated conductive wire, is used. As the electrically conductive material here, known electrically conductive materials can be mentioned. From the aspect of electrical conductivity, metal materials such as copper, gold, aluminum, nickel and the like are preferable and copper and gold are more preferable. The sectional shape of a wire-like product made from an electrically conductive material (i.e., sectional shape of conductive path) may be a circle, a polygon or other shape, as mentioned above. From the aspect of reliable connection with a terminal of a conductive path or a circuit pattern, the shape is generally a circle.

The distance between the adjacent conductive paths in the finally obtained anisotropic conductive film depends on the thickness of insulating polymer film 1 and pitch (d2) of conductive wires 2 on principal plane 1a of the film with conductive wires 10A (Fig. 6 (b) , Fig. 6(c)). While subject to change depending on the pressing conditions and the like in the block forming step to be mentioned later, to set the distance between adjacent conductive paths in an anisotropic conductive film to fall within the aforementioned preferably range, the thickness of the insulating polymer film 1 is generally set to 20 - 200 µm and the pitch (d2) between conductive wires 2 is generally set to 20 - 200 µm.

The heating temperature and applied pressure for heating and pressurizing for integrating the insulating polymer film 1 and the conductive wire 2 on the core 4 in Step 1 vary depending on the material constituting the conductive wire 2 and insulating polymer film 1. The heating temperature is generally about 50 - 250°C, preferably about 100 - 200°C. The applied pressure is generally about 2 - 30 kgf/cm², preferably about 3 - 20 kgf/cm².

It is preferable to wind an insulating polymer film 1 and a conductive wire 2 around the core 4 to give a wound product 5 (Fig. 3(b)), which is placed as it is in a space permitting formation of a decompression or vacuum, and after decompressing or vacuumizing the space, heated and pressurized. That is, by placing the wound product 5 (Fig. 3(b)) under decompression or in vacuo before heating and pressurizing, the gap among core 4, insulating polymer film 1 and conductive wire 2 can be effectively decreased, which in turn makes the sequence of the conductive paths well-regulated in the anisotropic conductive film. As used herein, the decompression means a pressure lower than the atmospheric pressure and is generally a pressure lower than the atmospheric pressure by not less than 0.01 MPa, and vacuum means decompression particularly to a pressure lower than the atmospheric pressure by not less than 0.08 MPa. For efficient removal of the gap, the heating and pressurizing is more preferably applied in vacuo. While the method for decompression or vacuumization is not particularly limited, suction using a pump (vacuum pump) is preferable for workability.

The above-mentioned space permitting formation of a decompression or vacuum is, for example, the space inside a rigid bag (i.e., box having rigidity capable of retaining the shape without deformation when decompressed or vacuumized), the space inside a bag made of a flexible film and the like. The material of the rigid box is, for example, metals such as steel, aluminum, stainless steel, carbon steel, bronze and the like, plastics such as polyethylene, polyurethane, acrylic resin, polyamide, polycarbonate and the like, and the like. As the flexible film, a metal film such as aluminum and the like, plastic film such as nylon film, polyester film, polyethylene film, polyimide film and the like or a laminate film wherein an aluminum film and the like are laminated on a polyethylene film and the like, and the like can be used.

When a bag made of a flexible film is used and the space inside the bag is vacuumized, the bag closely adheres to the wound product 5, whereby more effectively removing the gap.

In pressurizing for achieving the heating and pressurizing, a uniform pressure is preferably applied to a core so that the winding state (pitch, winding direction etc.) of the conductive wire may not be disturbed. For this reason, a method including introducing a compressed air into the above-mentioned space (space permitting formation of a decompression or vacuum) is preferably employed. In the case of the method including introduction of compressed air, the use of an inert gas such as nitrogen gas and the like as the compressed air preferably enables suppression of oxidization of the conductive wire.

### [Step 2 (step for forming a block integrating plural films with conductive wires)]

In the Step 2, plural films with conductive wires, which have been prepared in the aforementioned Step 1, are layered such that the conductive wires 2 of the adjacent films are in parallel relation to give a laminate, which is then heated and pressurized to form a block integrating plural films with conductive wires. The heating and pressurizing is a treatment for welding at least an insulating polymer film with a conductive wire between adjacent films with conductive wires. Preferably, the insulating polymer film is welded with the conductive wires and heating and pressurizing are applied to weld-adhering the insulating polymer films.

In the above-mentioned heating and pressurizing treatment, the heating temperature is generally within the range of from the softening temperature of resin (elastomer) constituting the insulating polymer film to about 300°C (specifically, 50 - 300°C). When a thermosetting resin is used as the insulating polymer film 1, heating at a temperature lower than the setting temperature is preferable. The applied pressure is generally about 5-30 kgf/cm², preferably about 5-20 kgf / cm² .

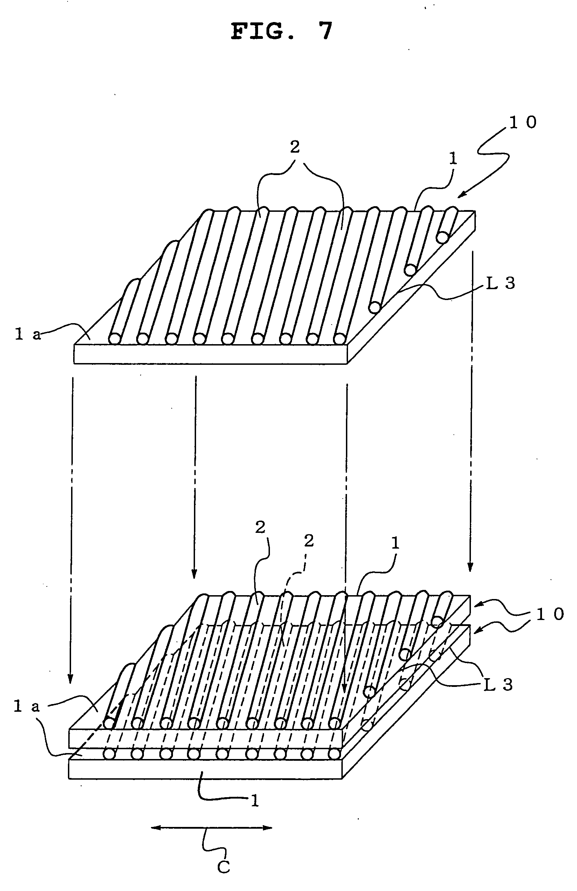

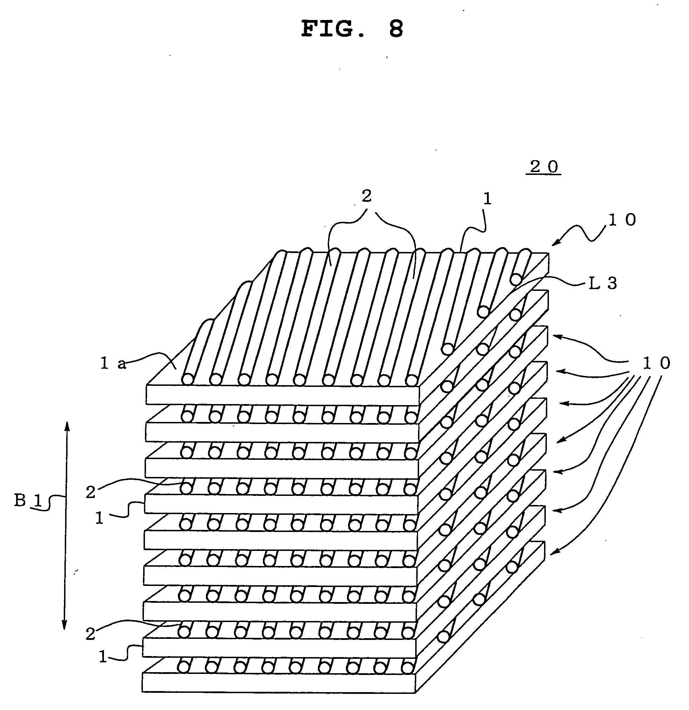

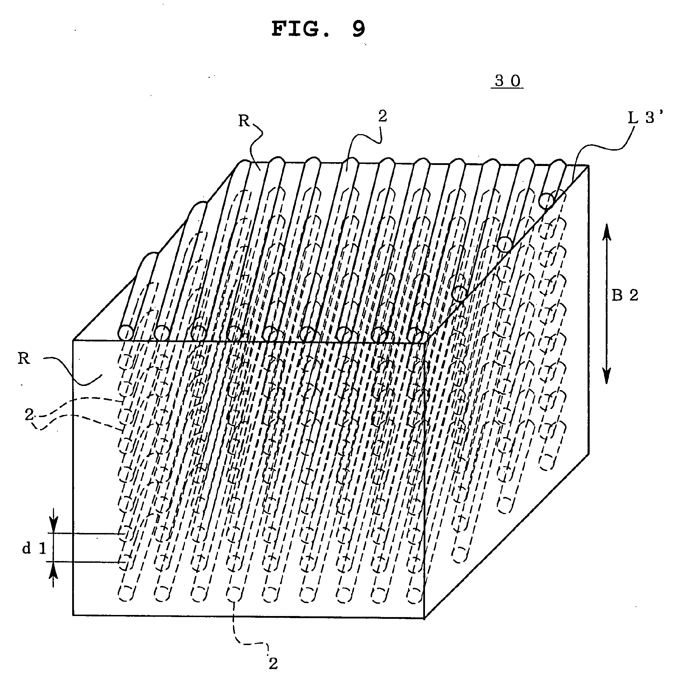

Fig. 7 - Fig. 9 show a manner wherein films with conductive wires 10A (Fig. 5(a), Fig. 6), wherein (the center line L1 of) the aforementioned plural conductive wires 2 are inclined at an angle (α1) with the predetermined linear side L3 of the principal plane 1a of the insulating polymer film 1, are accumulated (Fig. 7), such that the linear sides L3 of the adjacent insulating polymer films 1 are in parallel relation, and the thus-obtained laminate 20 (Fig. 8) is subjected to heating and pressurizing to form a block 30 (Fig. 9).

In the present invention, plural films with conductive wires 10A are integrated in Step 2, and a block 30 having a structure wherein an insulating resin R is disposed between plural conductive wires 2 provided in parallel to each other in the vertical (direction of accumulation) and horizontal direction is formed, as shown in Fig. 9.

In Step 2, a laminate comprising plural films with conductive wires is heated and pressurized to give a block integrating plural films with conductive wires. In Step 2, too, in the same manner as in the above-mentioned step 1, prior to heating and pressurizing, a laminate comprising plural films with conductive wires is preferably set in a space permitting formation of a decompression or vacuum and after decompressing or vacuumizing the space, heated and pressurized. In this way, the gap between films with conductive wires vertically laminated can be removed, and when the gap remains in a film with conductive wires, such gap can be preferably removed, thereby making the sequence of the conductive paths well-regulated in the anisotropic conductive film (structural precursor). As used herein, the decompress and vacuum mean the same as in the aforementioned step 1, and as the space permitting formation of a decompression or vacuum, the space inside the aforementioned rigid box or the space inside a bag made of a flexible film can be used. The method for achieving decompression or vacuum is not particularly limited but the aforementioned suction using a pump is preferable from the workability. In Step 2, a bag made of a flexible film is preferably used to achieve decompression or vacuum, in the same manner as in the aforementioned Step 1. When a bag made of a flexible film is used, the bag closely adheres to the laminate upon vacuumization of the space inside the bag, and the gap between the accumulated films with conductive wires can be more effectively removed.

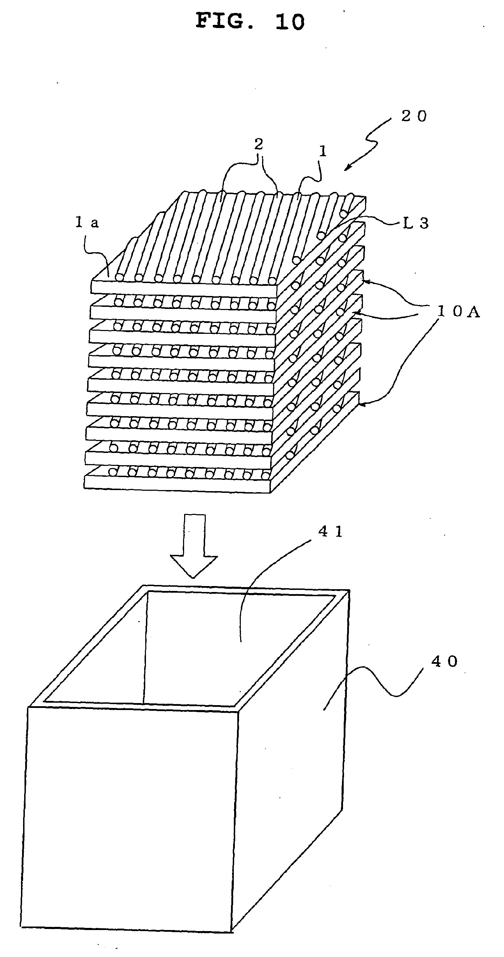

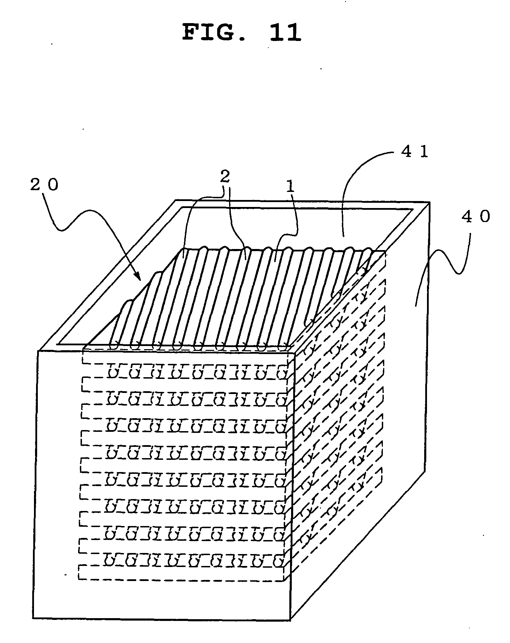

More preferable results can be obtained when the heating and pressurizing treatment in Step 2 is conducted in the following manner. That is, as shown in Figs. 10 and 11, laminate 20 is housed in a box 40, which is a heat resistant box having a size leaving some clearance between the inside surface and the laminate 20 upon accommodation of the laminate 20 and an opening 41 for entry of the laminate 20, and in this state (as shown in Fig. 10), laminate 20 is set in the space inside the aforementioned bag made of a flexible film together with the heat resistant box 40, and after decompressing or vacuumizing the space, heated and pressurized. In this way, the plural films with conductive wires 10A constituting the laminate 20 can be prevented from being out of position during pressing and the direction of inclination and inclination angle of the plural conductive wires (conductive paths) of the anisotropic conductive film (structural precursor) to be produced become more uniform. By the above-mentioned leaving "some clearance" is meant a clearance of about 0.5 - 20 mm between the lateral surface of the laminate and the inside surface of the box. The "heat resistance" of the heat resistant box means absence of deformation or softening (melting) during the above-mentioned heat treatment, and examples of the above-mentioned heat resistant box include a metal box made of aluminum (hereinafter also to be simply referred to as "alumi"), steel, stainless steel and the like and a ceramic box.

### [Step 3 (step for cutting block)]

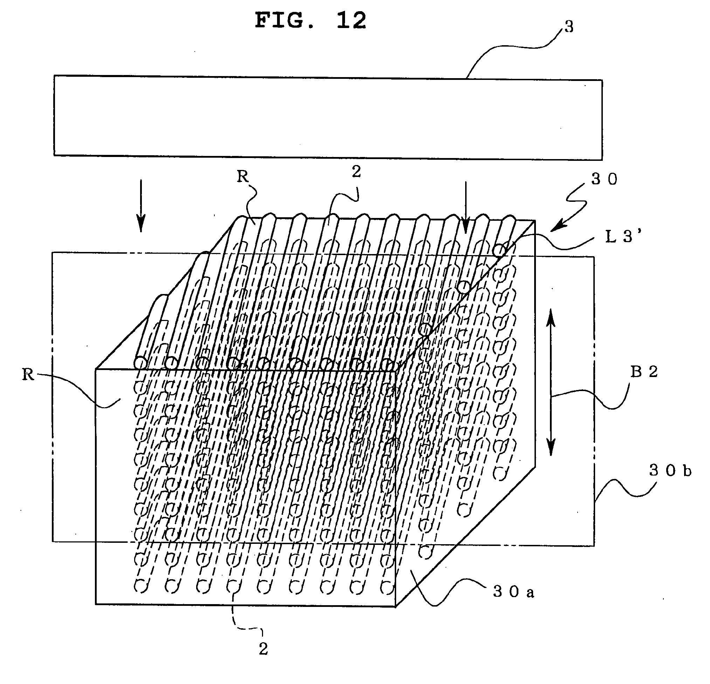

In this Step 3, the block prepared in the aforementioned Step 2 is cut along the plane forming an angle with conductive wire in a predetermined film thickness to give an anisotropic conductive film (structural precursor). Fig. 12 shows an embodiment in which block 30 (Fig. 9) obtained by accumulating films with conductive wires 10A (Fig. 5(a), Fig.6) wherein (the center line L1 of) the aforementioned conductive wire 2 is inclined at an angle (α1) with the linear side L3 of the principal plane 1a of the insulating polymer film 1.

In Fig. 12, the cutting tool 3 is a cutter. However, as long as a film can be cut out from a block in this step, it is not limited to a cutter, but various cutting tools (wire saw, slicer, plane, laser etc.) can be used.

In the embodiment shown in Fig. 12, block 30 is cut along the plane 30b as the cutting plane, which plane 30b is perpendicular to the predetermined linear edge side L3' derived from the predetermined linear side L3 (see Fig. 6 - Fig. 8) of the principal plane 1a of the insulating polymer film 1 in the film with conductive wires in the block 30. That is, as the film with conductive wires, a film with conductive wires 10A (Fig. 5(a), Fig. 6) wherein (the center line L1 of) the conductive wire 2 is inclined at an angle (α,1) to the predetermined linear side L3 of the principal plane 1a of the insulating polymer film 1, is used, and the block 30 is cut along the plane 30b as a cutting plane, which plane 30b is perpendicular to the linear edge side L3' of the block 30 as the standard, which is derived from the predetermined linear side L3 of the principal plane 1a of the insulating polymer film 1. As a result, the inclination angle (inclination angle (α1) of the center line L1 of the conductive wire 2 relative to the predetermined linear side L3 of the principal plane 1a of the insulating polymer film 1) of the conductive wire 2 set for the film with conductive wires 10A directly becomes an angle (α) formed by (the center line L1 of) the conductive path 52 with the line L2 perpendicular to the principal plane 51a of the film substrate 51 in the anisotropic conductive film (Fig. 2) to be produced. Accordingly, determination of the cutting plane in the cutting step is easy, and an anisotropic conductive film (structural precursor), wherein plural conductive paths are inclined at the objective inclination angle and the directions of inclination between plural conductive paths have high uniformity (plural conductive paths are inclined at a constant direction), can be certainly produced. In addition, because the size of the film (product size) obtained by cutting is unified, obliterating the problem of drastic fall in the yield.

In contrast, when an anisotropic conductive film is cut out as a film with conductive wires, from a block prepared using a film wherein (the center line of) the conductive wire is not inclined relative to the linear side of the principal plane of the insulating polymer film, such as a film with conductive wires 10B (Fig. 5(b)), it is cut in the direction perpendicular to the center line of the conductive wires. As a result, a structural precursor wherein the center line L1 of the conductive path 52 and the thickness direction (direction of arrow X in Fig. 1) of the film substrate 51 are substantially parallel as shown in Fig. 1 can be produced. In addition, by cutting the block such that the perpendicular line of the cutting face and the center line of the conductive wires form an angle, a structural precursor wherein the center line L1 of each conductive path 52 and the perpendicular line L2 of the principal plane of the film substrate 2 form an angle (α) as shown in Fig. 2 can be produced.

According to the production method of the present invention, a structural precursor produced in this way, which is free of protrusion of the end of a conductive path comprising a conductive wire from the principal plane of a film substrate, is subjected to a reactive ion etching (RIE). To be specific, each of the both principal planes of the film substrate of the structural precursor is subjected to an RIE to allow protrusion of both ends of the conductive path from the both principal planes of the film substrate to complete the anisotropic conductive film. As described above, the production method of the present invention comprises a step of protruding a conductive path from the principal plane of a film substrate by applying a reactive ion etching to the principal plane of a film substrate of a structural precursor to remove an insulating polymer around the conductive path. As used herein, a structural precursor comprises a film substrate made from an insulating polymer and plural conductive paths comprising conductive wires, wherein the plural conductive paths are insulated from each other and penetrate the film substrate, and an end face of the conductive path is present in the same plane as the principal plane of the film substrate.

The reactive ion etching (RIE) is a dry etching method utilizing a chemical reaction in a gaseous phase of reactive gas, reactive plasma, radical and the like, which is used as one method for micro processing of various semiconductor elements. As mentioned above, the anisotropic conductive film produced by the present invention has a comparative small outer diameter and conductive paths disposed at a narrow pitch. The present inventors have found that, when the end of a conductive path is made to protrude from the principal plane of a film substrate by subjecting a structural precursor free of protrusion from the principal plane of the film substrate to a reactive ion etching (RIE), unequal protrusion heights and thicknesses of plural ends of a conductive path can be drastically reduced. As a result, even conductive paths having a comparative small outer diameter, disposed at a narrow pitch, and protruding at a height of not less than 5 µm, further not less than 10 µm, become free of inconvenience such as easy occurrence of short-circuit (contact) of adjacent ends of the conductive paths or presence of unprotruded ends, and a highly reliable anisotropic conductive film can be certainly obtained.

As the etching gas to be used for reactive ion etching (RIE) performed in the present invention, for example, oxygen gas, nitrogen gas, argon gas, fluorine gas, or reactive gas thereof, mixed gas thereof (mixed gas of any two kinds or more) and the like are used. Of these, a mixed gas of fluorine gas and oxygen gas is preferable and a mixed gas of CF₄ gas and O₂ gas is particularly preferable. CF₄ gas is preferable for etching precision (processing precision) and O₂ gas is preferable for etching rate (processing speed). The mixing ratio of the above-mentioned mixed gas (CF₄ gas (vol%) /O₂ gas (vol%)) is preferably 2/98 - 30/70, more preferably 5/95 - 20/80. When CF₄ gas is smaller in the amount than 2 vol% (O₂ gas is more than 98 vol%), the etching rate becomes markedly low, and when CF₄ gas exceeds 30 vol% (O₂ gas is less than 70 vol%), the etching rate becomes not more than half the etching rate of the case of 30 vol%, thus failing to achieve sufficient etching rate.

In RIE, an electric power (output) is preferably set to 1500 - 2500 W, more preferably 1800 - 2300 W, and a gas flow is preferably set to 0.2 - 1.0 L/min, more preferably 0.3 - 0.8 L/min. When the electric power is less than 1500 W, the etching rate markedly decreases, and when it exceeds 2500 W, the surface shape (etching shape) of the etched material tends to become nonuniform.

A reactive ion etching (RIE) is applied to each of the both principal planes of the film substrate of an anisotropic conductive film (structural precursor). By altering the setting of RIE for each principal plane, protrusion height of the end of a conductive path can be changed between one principal plane and the other principal plane of the film substrate. Fig. 13 is a sectional view of major part of an anisotropic conductive film obtained by subjecting both principal planes of an anisotropic conductive film (structural precursor) (Fig. 13(a)), wherein the center line L1 of conductive path 52 is substantially parallel to the thickness direction (direction of arrow X in the Figure) of film substrate 51 and the end of the conductive path is not protruded, to RIE. In the anisotropic conductive film shown in Fig. 13(b), the protrusion height of the end of conductive path 52 is substantially the same on the both principal planes of the anisotropic conductive film. In the anisotropic conductive film shown in Fig. 13(c), the protrusion height differs between both principal planes of the film. Fig. 14 is a sectional view of major part of an anisotropic conductive film obtained by subjecting both principal planes of an anisotropic conductive film (structural precursor) (Fig. 14(a)), wherein the center line L1 of conductive path 52 forms an angle (α) with the perpendicular line L2 of the principal plane of the film substrate 51, and the end of the conductive path is not protruded, to RIE. In the anisotropic conductive film shown in Fig. 14(b), the protrusion height of the end of conductive paths 52a, 52b is substantially the same on the both principal planes of the anisotropic conductive film. In the anisotropic conductive film shown in Fig. 14(c), the protrusion height differs between both principal planes of the film.

In the present invention, the end of a conductive path is protruded by such reactive ion etching, and the end may be subjected to a plating treatment (particularly nonelectrolytic plating treatment) to cover the protrusion with a material having high electroconductivity and superior in corrosion resistance, such as gold, nickel and the like. The thickness of coating here is generally about 0.5 - 5 µm, preferably 1 - 3 µm .

The anisotropic conductive film produced by the present invention preferably has a modulus of elasticity of the structure (anisotropic conductive film) as a whole of 10 - 30 MPa at 25 - 40°C, more preferably 10 - 20 MPa. The modulus of elasticity of the structure (anisotropic conductive film) as a whole.varies depending on the thickness, materials of the conductive path and film substrate, outer diameter of the conductive path, distance between adjacent conductive paths and the like of the anisotropic conductive film. When the modulus of elasticity of the structure (anisotropic conductive film) as a whole is within the preferable range, the anisotropic conductive film shows more superior flexibility between an electronic component and a circuit board with a low load. When the modulus of elasticity is less than 10 MPa, adhesion to an electronic component becomes easy, and the electronic component tends to be not easily released from the anisotropic conductive film after testing, and when the modulus of elasticity exceeds 40 MPa, the film may not be able to follow the shape of the surface of an electronic component having a surface structure wherein the terminal surface is set back from the surface of the component. Here, the modulus of elasticity is measured using a dynamic viscoelasticity measure apparatus (DMS210, Seiko Instruments Inc.). The measurement conditions are an extension mode relative to one direction from among the directions that the surface of the film substrate of the anisotropic conductive film expands at a constant frequency (10 Hz) at a temperature raise rate of 5°C/min and the measurement at -30°C - 200°C. The thickness of the sample to be input for measurement is the thickness (symbol D1 in Fig. 1(b), D2 in Fig. 2) of the film substrate in the anisotropic conductive film.

### Examples

The present invention is explained in detail by referring to examples, which are not to be construed as limitative.

### Example 1

An aluminum cylindrical core having a diameter of 320 mm and a length of 270 mm is set on a horizontal type regular winding machine (HPW - 02, Nittoku Engineering Co., Ltd.), on which a 50 µm-thick fluorocarbon resin film as a release film and one layer consisting of a 100 µm-thick urethane elastomer film having a rubber hardness of 75 degrees thereon are wound, and a heat resistant polyurethane coated wire (copper wire (diameter 25 µm) coated with heat resistant polyurethane in 2 µm thickness) having a diameter of 29 µm was wound 250 mm at a winding intervals (pitch) of 100 µm. As a release film, a 50 µm-thick fluorocarbon resin film was wound to cover the wound wire, and on the outside thereof, a 1 mm thick aluminum plate was set as a support plate along the cylindrical shape of the core.

A seal tape GS213 (Airtec Co., Ltd.) endurable of a high temperature of 200°C was adhered to cover a 80 µm-thick heat resistant nylon film (1000 mm x 1530 mm, WL 8400-003-60-1000-SHT9, Airtec Co., Ltd.,) endurable of a high temperature of 200°C and the center of the film was folded to give a bag capable of forming a vacuum space, and the above-mentioned core, the film and the wire and the support plate in integration were placed in this bag. The film space was hermetically sealed and sucked with a vacuum hose (connected to a vacuum pump) to vacuumize the film space. While maintaining the vacuum, the bag containing the wound product and the support plate was placed in a heat press treatable autoclave (Ashida Co., Ltd.). After setting, the inside of the tube was heated to make the temperature of the core 155°C (temperature inside the tube: 200°C), along with which the tube was pressed with a nitrogen gas to make the pressure inside the tube 10 kgf/cm². After the core temperature and the pressure in the tube reached the objective levels, the inside of the tube was cooled and only the core was taken out from the state when cast into an autoclave, whereby a roll-like product integrally containing the urethane elastomer film and the heat resistant urethane film was obtained.

Then one side of the aforementioned roll-like product was cut to give a plane-like product, from which 24 films with wires were cut out using a Thomson cutter, wherein plural heat resistant urethane coated wires were arranged and adhered in parallel to the linear side L2 of the thermoplastic urethane elastomer film at a pitch of 100 µm on a principal plane of a rectangular thermoplastic urethane elastomer film (120 mm x 62 mm). Then the 24 films with wires were arranged such that the wires were parallel to each other between plural films with wires, as shown in Fig. 7, the films were accumulated in the vertical direction and this laminate was placed in an aluminum box, as shown in Figs. 10 and 11.

As the above-mentioned aluminum box, a cuboid box as a whole having an opening on the upper surface, permitting entry of the laminate as it is thereinto, a depth completely accommodating the laminate and having a size leaving some clearance of 1.5 mm between the inside surface thereof and the lateral surface of the laminate (side surface of a thermoplastic urethane elastomer film).

A 10 mm-thick aluminum plate (120 x 62 mm) was placed into the above-mentioned aluminum box from an opening on the upper surface of the box and on the uppermost surface of the aforementioned laminate. In this state, the aluminum box containing the laminate was placed in the bag made of a nylon film, which permits formation of a vacuum space and was used in the above, and the film space was vacuumized. While maintaining the vacuum, the bag was placed in a heat press treatable autoclave (Ashida Co., Ltd.). The aluminum box was heated to a temperature of 175°C (temperature inside the tube: 200°C), along with which the tube was pressed with a nitrogen gas, such that the pressure inside thereof became 15 kgf/cm². After the temperature and the pressure in the tube reached the objective levels, the inside of the tube was cooled, whereby a block integrating the laminate was formed.

The block prepared in the above was cut with a wire saw (F-600, Yasunaga Corporation) along the plane forming an angle with the axis of the copper wires arranged inside in parallel to each other. As a result, anisotropic conductive films (structural precursors, 300 films, 60 mm x 120 mm, 80 µm thick), wherein the center line of the conductive path (copper wire) and the thickness direction of the film substrate were substantially parallel were obtained. The sequence of conductive paths of the 300 anisotropic conductive films (structural precursors) was observed with a stereoscopic microscope to find that the average distance between adjacent conductive paths in one film was within the range of 97 - 112 µm .

Then, both principal planes of 24 anisotropic conductive films (structural precursors) were subjected to RIE under the following conditions. Using a plasma etching system (Advanced Plasma, Co., Ltd.), etching gas was a mixed gas of CF₄ gas (10 vol%) and O₂ gas (90 vol%), output was 2000 W, gas flow was 0.5 L/min, and etching time was 30 min. By this treatment, the end of the conductive path (copper wire) was protruded from the both principal planes of the film substrate. The above-mentioned etching conditions were set to achieve a protrusion height of 15 µm.

Each of the above-mentioned 24 anisotropic conductive films wherein the end of the conductive path had been protruded, was observed for the protrusion state of the end of the conductive path (copper wire) on both the front and back surfaces of the film with a stereoscopic microscope. As a result, no anisotropic conductive film showed contacted ends of conductive paths on both the front and back surfaces of the film. In addition, a conductive path without protrusion of the end was not observed.

In addition, the protrusion height of the end of the conductive path on both the front and back surfaces of the film was measured with a microscope (OLYMPUS OPTICAL CO., LTD.). As a result, the protrusion height of the end of the conductive path on both the front and back surfaces of the film was within the range of 15 µm±3 µm in any anisotropic conductive film, and the protrusion state of the end of the conductive path was almost the same. Furthermore, the modulus of elasticity (25 - 40°C) of two of these 24 anisotropic conductive films was measured and found to be 13 - 17 MPa for both.

### Example 2

The structural precursors (24 sheets) obtained in the same manner as in Example 1 were subjected to RIE under the following conditions. One of the principal planes of each structural precursor was etched for 30 min using a mixed gas of CF₄ gas (10 vol%) and O₂ gas (90 vol%) as an etching gas under the conditions of output 2000 W and gas flow 0.5 L/min, and the other principal plane was etched for 60 min using the same etching gas at the same output and gas flow.

Each of the above-mentioned 24 anisotropic conductive films wherein the end of the conductive path had been protruded, was observed for the protrusion state of the end of the conductive path (copper wire) on both the front and back surfaces of the film with a stereoscopic microscope. As a result, no anisotropic conductive film showed contacted ends of conductive paths on both the front and back surfaces of the film. In addition, a conductive path without protrusion of the end was not observed.

In addition, the protrusion height of the end of a conductive path on both the front and back surfaces of the film was measured with a microscope (OLYMPUS OPTICAL CO., LTD.). As a result, the protrusion height of one of the principal planes was within the range of 15 µm±3 µm and the protrusion height of the other principal plane was within the range of 30 µm±3 µm in any anisotropic conductive film, and the protrusion state of the end of the conductive path was almost the same. Furthermore, the modulus of elasticity (25 - 40°C) of two of these 24 anisotropic conductive films was measured and found to be 13 - 17 MPa for both.

### Example 3

For cutting out a film with conductive wires from a plane-like product obtained by cutting one side of a roll-like block, 18 films with conductive wires in the sate shown in Fig. 6(c), wherein the conductive wires were sequenced and adhered at an inclination angle (α1) of 15 degrees relative to the linear side L3 of the thermoplastic urethane elastomer film, were cut out. A block was prepared in the same manner as in Example 1 except that the films were accumulated in the vertical direction as shown in Fig. 7. The prepared block was cut in a predetermined film thickness with a wire saw (F-600, Yasunaga Corporation), such that the cutting plane relative to a predetermined linear edge side (linear edge side derived from the linear side L3 of thermoplastic urethane elastomer film) of the block becomes the perpendicular direction to give 270 anisotropic conductive films (structural precursors, 50 - 120 mm x 60 mm, thickness 80 µm) . The sequences of the conductive paths of the 270 anisotropic conductive films (structural precursors) were observed with a stereoscopic microscope to find that the average distance between the adjacent conductive paths in one film was within the range of 98 - 113 µm. In addition, the cutting face perpendicular to the principal plane of the film substrate was observed with a stereoscopic microscope at 10 points in one film. As a result, an angle formed by the center line of each conductive path with the perpendicular line of the principal plane of a film substrate was within the range of 13 - 17°, and the sequence of respective conductive paths and the inclination state were almost the same.

The obtained structural precursors (24 sheets) were subjected to RIE under the following conditions. One of the principal planes of each structural precursor was etched for 30 min using a mixed gas of CF₄ gas (10 vol%) and O₂ gas (90 vol%) as an etching gas under the conditions of output 2000 W and gas flow 0.5 L/min, and the other principal plane was etched for 60 min using the same etching gas at the same output and gas flow.

The above-mentioned 24 anisotropic conductive films were observed for the protrusion state of the end of the conductive path (copper wire) on both the front and back surfaces of the film with a stereoscopic microscope. As a result, no anisotropic conductive film showed contacted ends of conductive paths on both the front and back surfaces of the film. In addition, a conductive path without protrusion of the end was not observed.

In addition, the protrusion height of the end of the conductive path on both the front and back surfaces of the film was measured with a microscope (OLYMPUS OPTICAL CO., LTD.). As a result, the protrusion height of one of the principal planes was within the range of 15 µm±3 µm and the protrusion height of the other principal plane was within the range of 30 µm±3 µm in any anisotropic conductive film, and the protrusion state of the end of the conductive path was almost the same. Furthermore, the modulus of elasticity (25 - 40°C) of two of these 24 anisotropic conductive films was measured and found to be 13 - 16 MPa for both.

### Comparative Example 1 (formation of protrusion by wet etching)

The structural precursor (one film) prepared in Example 1 was immerse in a hydrocarbon solvent (toluene) for 20 min. Then, the protrusion height of the end of the conductive path was measured with a microscope (OLYMPUS OPTICAL CO., LTD.) to fine dispersed values of 3 - 9 µm depending on the conductive paths. Although the maximum value of the protrusion height did not reach 10 µm, the difference between the maximum value and the minimum value of the protrusion height reached 6 µm, thus indicating a great dispersion in the protrusion height of the ends of plural conductive paths.

### Comparative Example 2 (formation of protrusion by plating)

Twelve anisotropic conductive films (structural precursors) prepared in the same manner as in Example 1 were subjected to a procedure for forming a protrusion of a conductive path by nonelectrolytic nickel plating, without conducing etching by a plasma treatment. To be specific, 12 structural precursors were each immerse in a nonelectrolytic nickel plating solution (85°C) for 60 min. Then, the protrusion height of the end of the conductive path on both the front and back surfaces of the film was measured with a microscope (OLYMPUS OPTICAL CO., LTD.). As a result, the protrusion height of the end of a conductive path was within the range of 8 - 12 µm on both the front and back surfaces of the film in any anisotropic conductive film. Observation with a stereoscopic microscope revealed that a protrusion was formed in all conductive paths but the protrusions were adhered to each other in about 5 to 10% of the area of the film as a whole. Thereafter, the film was further immersed in a nonelectrolytic nickel plating solution (85°C) for 60 min. While the protrusion height of the end of the conductive path after the immersion was within the range of 13 - 16 µm, the protrusions were adhered to each other in about 40% of the area of the film as a whole.

The anisotropic conductive films of the above-mentioned Examples 1 - 3 were subjected to the following evaluation test 1.

### Evaluation test 1

The anisotropic conductive films prepared in Examples 1 - 3 were subjected to the following connection test (electroconductive test) between an electronic component and a circuit board.

### [Specification of electronic component for evaluation]

size of component: length 3.8 mm x width 3.8 mm x thickness 2 mm
size of electrode: length 0.3 mm x width 0.3 mm
number of electrodes: 20
state of presence of electrode: electrode surface was 20 µm below the surface of the component
distance between electrodes (pitch):0.6 mm

### [Specification of circuit board for evaluation]

substrate: glass epoxy substrate (FR-4)
entire thickness including circuit pattern: 1 mm
ratio of circuit width and interval width of circuit pattern: (0.3 mm : 0.3 mm)

### [Evaluation method]

An anisotropic conductive connector was disposed between the above-mentioned electronic component for evaluation and the circuit board for evaluation, a contact load was applied from the electronic component side to see if all the terminals (electrodes) of the electronic component are continued with the circuit board (namely, if all the contact points continue).

### [Results]

The contact load necessary for continuity of all points was 3 MPa when the anisotropic conductive film of Example 1 was used; 2.5 MPa when the anisotropic conductive film of Example 2 was used; and 2.5 MPa when the anisotropic conductive film of Example 3 was used.

## Claims

1. A method of producing an anisotropic conductive film, which comprises preparing a structural precursor comprising a film substrate made from an insulating polymer and plural conductive paths comprising conductive wires, which penetrate in the thickness direction of the film substrate while being insulated from each other, wherein an end face of each conductive path is in the same plane as the principal plane of the film substrate, applying reactive ion etching to the aforementioned principal plane of the film substrate to protrude the aforementioned end of the conductive path from the aforementioned principal plane of the film substrate.

2. The production method of claim 1, which further comprises a plating treatment of the end of the conductive path after the aforementioned reactive ion etching.

3. The production method of claim 1, wherein the structural precursor is prepared by the following method (A):
(A): winding an insulating polymer film around the circumference of a core,
then helically winding a conductive wire around the circumference of the insulating polymer film at a predetermined pitch,
heating and pressurizing to integrate the insulating polymer film and the conductive wire on the core to give a roll-like product,
removing said roll-like product from the core,
incising the roll-like product to give a plane-like product,
cutting out plural films with conductive wires from the plane-like product,
then laminating the plural films with conductive wires such that the conductive wires on the adjacent films are parallel to each other to give a laminate,
heating and pressurizing the laminate to form a block integrating the plural films with conductive wires, and
then cutting the block in a predetermined film thickness along the plane forming an angle with the conductive wire to give the structural precursor.

4. The production method of claim 3, wherein the insulating polymer film and the conductive wire wound around the core are set together with the core in a space permitting formation of a decompression or vacuum and, after decompressing or vacuumizing the space, heated and pressurized to integrate the insulating polymer film and the conductive wire on the core.

5. The production method of claim 4, wherein said space permitting formation of a decompression or vacuum is an inner space of a bag made of a flexible film.

6. The production method of claim 4, wherein said pressing is done by introducing a compressed air into said space permitting formation of a decompression or vacuum.

7. The production method of claim 3, wherein the laminate is set in a space permitting formation of a decompression or vacuum, and after decompressing or vacuumizing the space, heated and pressurized.

8. The production method of claim 7, wherein the space permitting formation of a decompression or vacuum is an inner space of a bag made of a flexible film.

9. The production method of claim 7, wherein the laminate is housed in a heat resistant box having a size leaving some clearance between the inside surface of the box and the lateral surface of the laminate upon accommodation of the laminate, set in the space inside the bag made of a flexible film together with the heat resistant box, and after decompressing or vacuumizing the space, heated and pressurized.
